# EUROPÄISCHE PATENTSCHRIFT

(11) **EP 0 582 580 B1**
(45) Veröffentlichungstag und Bekanntmachung des Hinweises auf die Patenterteilung: **25.10.1995**
(21) Anmeldenummer: 92906749.4
(22) Anmeldetag: 27.02.1992
(51) Int. Cl.: G01F 1/66, G01F 1/704, G01F 1/86, G01F 1/00, G01N 21/37

(54) **VERFAHREN ZUR EINSTELLUNG DES MASSENFLUSSES EINER GASKOMPONENTE IN EINEM GASGEMISCH MITTELS OPTISCHER ABSORPTION UND ANWENDUNG DES VERFAHRENS**
OPTICAL-ABSORPTION METHOD FOR CONTROLLING THE MASS FLOW OF A GAS COMPONENT IN A GASMIXTURE, AND USE OF THE METHOD
PROCEDE POUR LE REGLAGE DU FLUX MASSIQUE D'UN CERTAIN GAS D'UNE MIXTURE PAR ABSORPTION OPTIQUE ET APPLICATION DE CE PROCEDE

(43) Veröffentlichungstag der Anmeldung: 16.02.1994
(73) Patentinhaber: SIEMENS AKTIENGESELLSCHAFT, 80333 München (DE)
(72) Erfinder: INTEMANN, Andreas, D-85356 Freising (DE); KÖRNER, Heinrich, D-83052 Bruckmühl (DE); HIEBER, Konrad, D-85630 Neukeferloh (DE)
(86) Internationale Anmeldenummer: DE9200157
(87) Internationale Veröffentlichungsnummer: WO9317304

(56) Entgegenhaltungen:
- EP-A- 0 215 287
- DE-A- 4 032 962
- ADVANCES IN INSTRUMENTATION Bd. 42, Nr. 1, 1987, Research Triangle Park, NC, US, Seiten 547-555 ; R.F. Vogelsang : "Second Generation - Analyzer Cross Flow Techniques - Precision, Sensitive, Continuous Measurements"
- PATENT ABSTRACTS OF JAPAN vol. 15, no. 133 (C-820), 2. April 1991 ; & JP-A-30 16 555

## Beschreibung

Die vorliegende Erfindung betrifft ein Verfahren zur Einstellung des Massenflusses einer Gaskomponente in einem Gasgemisch mittels optischer Absorption und eine Anwendung des Verfahrens.

In vielen Bereichen der Technik, z.B. in der Mikroelektronik oder beim Verschleißschutz finden bei CVD-Beschichtungsprozessen (Chemical vapor deposition) zunehmend flüssige und feste Ausgangsstoffe bzw. -substanzen Verwendung, die im Vergleich zu bisher üblichen Gasen, wie z.B. SiH₄, B₂H₆, einen niedrigen Dampfdruck besitzen. Diese Entwicklung resultiert zum einen aus Sicherheitsgründen (es soll bei etwaigen Unfällen wenn überhaupt nur eine lokale Kontamination stattfinden) und zum anderen aus verfahrensbedingten Vereinfachungen. Im letzteren Falle sollen auch Schichten aus Verbindungen durch einfache thermische Zersetzung einer Ausgangssubstanz herstellbar sein. Ein typisches Beispiel ist die Verwendung von TEOS (Tetra-EthylOrtho-Silikat) für die Abscheidung von SiO₂ in der Halbleitertechnik. Diese Flüssigkeit besitzt bei Raumtemperatur einen Dampfdruck von einigen Hundert Pa. Metallorganische Verbindungen zur Metallabscheidung liegen - bei Raumtemperatur - meist in fester Form vor. Der Dampfdruck liegt häufig unter einhundert Pa. Ihre zuverlässige und zeitkonstante Dosierung ist eine unabdingbare Voraussetzung für die reproduzierbare Abscheidung von Schichten.

Zur gezielten Dosierung von gasförmigen Stoffen werden heute gewöhnlich kommerziell erhältliche Geräte verwendet, die als "Mass Flow Controller" oder "Mass Flow Meter" bezeichnet werden. Dabei handelt es sich um Geräte, die den Massenfluß des gasförmigen Stoffes über die Wärmeleitfähigkeit messen.

Derartige Geräte arbeiten so, daß in einer Leitung für den zu untersuchenden gasförmigen Stoff ein Druckabfall erzeugt wird, was beispielsweise durch Blenden oder Laminarelemente erfolgen kann. Über eine parallel dazu angeordnete Bypass-Kapillare kann je nach Druckdifferenz ein Teil des gasförmigen Stoffes strömen. An dieser Kapillare sind Heizdrähte angebracht, die den gasförmigen Stoff typischerweise auf 70 bis 100°C aufheizen. Weiterhin sind dabei Thermoelemente vorgesehen, welche die Temperaturverteilung messen.

Fließt kein Gas durch die Leitung, so entsteht kein Druckabfall im System und damit auch keine Strömung in der Kapillare. Es ergibt sich daher eine homogene symmetrische Temperaturverteilung. Die Abweichung von dieser Verteilung, die sich bei einer Strömung ergibt, kann als Maß für den Massenfluß zugrunde gelegt werden. Geräte der genannten Art sowie ihre Funktion sind beispielsweise in einem Firmenprospekt "V-MAX The ultimate vapor source" der Firma Tylan GmbH in Eching bei München beschrieben.

Ein Problem bei derartigen Geräten besteht darin, daß für das Meßprinzip ein Vordruck von mindestens 10³ bis 10⁴ Pa erforderlich ist, um den Druckabfall im Meßsystem zu erzeugen. Dieser mindestens benötigte Eingangsdruck kann bei vielen Stoffen bzw. Substanzen über ihren Dampfdruck erst bei höheren Temperaturen von z.B. mehr als 100°C erzeugt werden. Durch die Notwendigkeit der Erwärmung der Stoffe bzw. Substanzen ergeben sich folgende Nachteile:

Die Stoffe sind teilweise nicht genügend thermisch stabil und zersetzen sich, bevor der nötige Dampfdruck erreicht ist.

Die kommerziell erhältlichen "Mass Flow Controller" sind normalerweise auf eine Betriebstemperatur von 70°C beschränkt. Lediglich in Sonderausführungen kann diese Temperatur etwas höher liegen.

Das Meßprinzip verliert an Genauigkeit, das Nutzsignal wird sehr klein und die Geräte können allenfalls nur noch bei einer festen Temperatur betrieben werden.

Eine weitere Beschränkung in der Benutzung von Mass Flow Controllern besteht darin, daß sie auf einen bestimmten Stoff bzw. eine bestimmte Substanz kalibriert werden müssen, da jeder Stoff eine andere Wärmeleitfähigkeit besitzt. Dies macht einen universellen Einsatz nicht möglich oder schränkt ihn doch entscheidend ein. Darüber hinaus sind oft die Wärmeleitfähigkeitsdaten nicht oder nur sehr ungenau bekannt.

Eine weitere Möglichkeit, Stoffe mit niedrigem Dampfdruck zu dosieren, besteht in der Verwendung eines inerten Trägergases. Dabei wird ein Behälter vom Trägergas durchströmt und es stellt sich im Idealfall eine Sättigung des Trägergases gemäß dem Partialdruckverhältnis der Stoffe ein.

In der Regel ist dabei aber keine absolute Kontrolle über den Massenfluß möglich, da der tatsächliche Sättigungsgrad stark schwanken kann und das Trägergas bei Verwendung von Mass Flow Controllern auch zur Wärmeleitfähigkeit beiträgt.

Generell werden gegenwärtig zur Stoffdosierung folgende Maßnahmen praktiziert:

Es erfolgt keine Regelung des Stoffflusses, was zwar technisch und ausrüstungsmäßig die einfachste Lösung ist, jedoch keinerlei Möglichkeit zur Kontrolle bietet.

Die Verwendung von Mass Flow Controllern und Mass Flow Metern stellt eine einfache Kontrollmöglichkeit dar, die für niedrige Temperaturen von 40 bis 50°C verwendbar ist. Muß dabei mit einem Trägergas und höheren Temperaturen gearbeitet werden, so ist auch dies aus den obengenannten Gründen unbrauchbar.

Bei einer Druckregelung wird der Druck im vom Trägergas durchströmten Verdampfersystem mittels Druckaufnehmer und Regelventil konstant gehalten. Dabei geht man von einer gleichbleibenden Sättigung des Trägergases mit dem zu dotierenden Stoff gemäß dem Dampfdruckverhältnis aus. Ein Nachteil ist dabei jedoch, daß zum einen die Dampfdruckkurve des Stoffes genau bekannt sein muß, was in der Regel nicht der Fall ist, und zum anderen von idealen Verhältnissen - u.a. große Verweilzeit des Trägergases im Verdampfer - ausgegangen wird.

Zusammenfassend ist festzustellen, daß alle bisher bekannten Möglichkeiten vor allem im Temperaturbereich über 50°C nicht zufriedenstellend sind und eine sichere absolute Aussage über den tatsächlichen Massentransport eines Stoffes im Verlauf eines Prozesses, etwa in einem CVD-Prozeß nicht möglich ist.

Aus der EP-A-215 287 ist ein Analyseverfahren bekannt, das mit dem der vorliegenden Erfindung zugrundeliegenden Meßprinzip auf der Basis der optischen Absorption in verschiedenen Wellenlängenbereichen übereinstimmt. Ein ebenfalls zur Bestimmung des Massenflußes einsetzbares, auch auf dem gleichen Meßprinzip beruhendes Absorptionsmeßgerät ist aus der JP-A-30 16 555 bekannt.

Der vorliegenden Erfindung liegt die Aufgabe zugrunde, Möglichkeiten zur Verbesserung der Dosierung des Massenflusses von Stoffen mit insbesondere niedrigem Dampfdruck zu finden, die insbesondere auch zur in-situ-Kontrolle der Dosierung der Stoffe bei Abscheideprozessen geeignet sind.

Diese Aufgabe wird erfindungsgemäß durch ein Verfahren gemäß Patentanspruch 1 gelöst.

Weiterbildungen der Erfindung sind Gegenstand von Unteransprüchen.

Die Erfindung wird im folgenden anhand von in den Figuren der Zeichnung dargestellten Ausführungsbeispielen näher erläutert.

Es zeigt:
- Figur 1: eine schematische Darstellung eines an sich bekannten Gasanalysegerätes; und
- Figur 2: eine schematische Darstellung einer Anwendung des erfindungsgemäßen Verfahrens zur Stoffdosierung unter Verwendung von Trägergas.

Die Erfindung beruht darauf, für die Ermittlung der tatsächlichen Konzentration eines Stoffs ein an sich bekanntes, auf der Basis der optischen Absorption in verschiedenen Wellenlängenbereichen arbeitendes Meßprinzip zu verwenden. Damit wird es möglich, bisher nicht erfaßbare Meßbereiche, insbesondere bei Prozessen mit Unterdruck, für die Regelung des Massenflusses in einem Abscheidungsprozeß nutzbar zu machen. Hierbei kann der Wellenlängenbereich von Ultraviolett über den sichtbaren Bereich bis in den fernen Infrarotbereich entsprechend der Zusammensetzung des zu untersuchenden Stoffes - organisch, metallorganisch, Metallhalogenide.... - ausgenutzt werden. Eine große Abschätzung ergab, daß mit einem breitbandig arbeitenden System noch eine Dichte der optisch aktiven Teilchen von ca. 10¹⁴ cm⁻³ detektiert werden kann. Dies entspricht bei einem Absolutdruck von 100 Pa einer Trägergassättigung von 0.01 Promille. Diese, wider Erwarten hohe Empfindlichkeit gestattet es, die Konzentration auch im Unterdruckbereich zu messen.

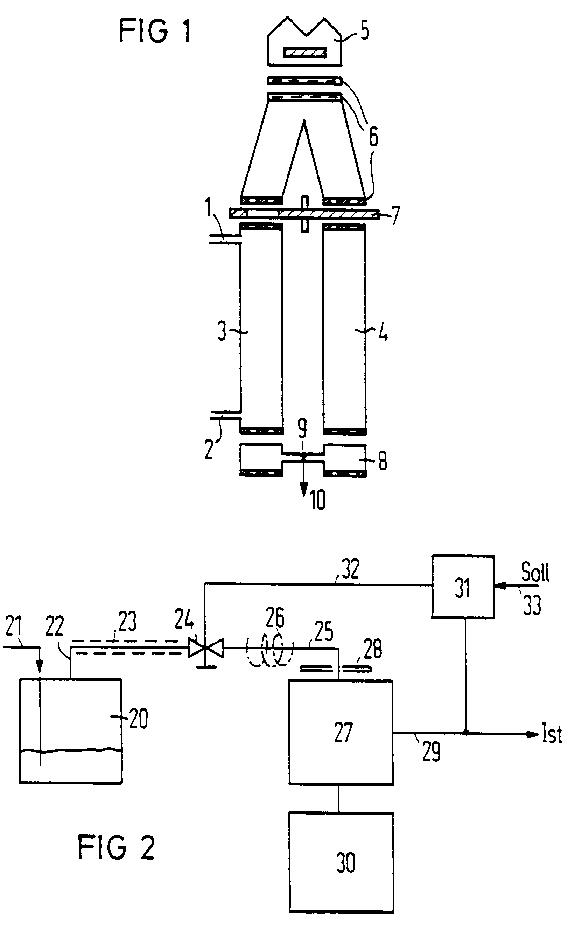

Figur 1 zeigt schematisch den Aufbau eines Gasanalysegerätes, wie es beispielsweise in einem Prospekt der Anmelderin mit dem Titel "Gasanalysegeräte ULTRAMAT 5 OXYMAT 5" mit der Nr. A19100-E681-A21-V4 beschrieben ist.

Gemäß der schematischen Darstellung nach Figur 1 besitzt ein derartiges Gerät eine Absorptionsküvette 3 mit einem Einlaß 1 und einem Auslaß 2 für einen zu untersuchenden Stoff. Weiterhin ist eine Referenzküvette 4 vorgesehen, die nur mit einem reinen inerten Gas gefüllt ist. Von einer Lichtquelle 5 wird über optische Filter 6 Licht in einem vorgegebenen Wellenbereich in die Küvetten 3 und 4 eingestrahlt. Zwischen den optischen Filtern 6 und den Küvetten 3 und 4 ist ein rotierender Chopper 7 vorgesehen, so daß Licht abwechselnd in die Absorptionsküvette 3 und die Referenzküvette 4 eingestrahlt wird. Auf der dem genannten optischen System abgewandten Seite der Küvetten 3 und 4 ist ein Detektor 8 optisch an das Küvettensystem angekoppelt. Je nach Konzentration des zu untersuchenden Stoffes in der Absorptionsküvette 3 ergeben sich an einem schematisch dargestellten Mikroströmungsfühler 9 im Detektor 8, welcher mit einem Gas gefüllt ist, das im selben Wellenlängenbereich absorbiert wie die zu untersuchende Substanz, unterschiedliche Druckverhältnisse aufgrund unterschiedlich starker Erwärmung in den jeweiligen Detektorkammern auf der Seite der Absorptionsküvette 3 und der Referenzküvette 4. Aufgrund dieses Druckunterschiedes strömt nun Gas durch eine Verbindungsröhre, in der sich der Mikroströmungsfühler 9 befindet, von einer Detektorkammer in die andere, wobei der Mikroströmungsfühler 9 ein Signal liefert, welches ein Maß für die Konzentration des zu untersuchenden Stoffes in der Absorptionsküvette 3 darstellt, das an einem schematisch dargestellten Ausgang 10 zur Verfügung steht.

Das an sich bekannte Gasanalysegerät ist, wie aus dem oben genannten Prospekt hervorgeht, zur quantitativen Analyse von Sauerstoffkonzentrationen und von unterschiedlichen infrarotabsorbierenden Verbindungen geeignet. Es wurde noch nie im Unterdruckbereich eingesetzt. Der konstruktive Aufbau des Gerätes insgesamt (Quarzfenster, Küvetten usw.) ist darauf abgestellt, daß immer nur ein kleiner Teil des zu untersuchenden Stoffes in die Absorptionsküvette 3 geleitet wird.

Erfindungsgemäß ist demgegenüber vorgesehen, den zu dosierenden Stoff in seiner Gesamtheit über eine Absorptionsküvette zu leiten. Ein konstruktiv angepaßtes Gerät der in Figur 1 schematisch dargestellten Art wird bei der Durchführung des erfindungsgemäßen Verfahrens etwa in einem Beschichtungsprozeß in der Mikroelektronik in der in Figur 2 dargestellten Weise verwendet. Ein Behälter 20 enthält dabei den zu dosierenden Stoff, wobei über eine schematisch dargestellte Leitung 21 ein Trägergas in den Behälter 20 eingeleitet wird. Im Behälter 20 wird das Trägergas durch den zu dosierenden Stoff geleitet, um eine Sättigung des Trägergases mit dem Dotierstoff zu erreichen. Der zu dosierende Stoff wird mittels des Trägergases über eine Leitung 22, ein Regelventil 24 und eine Leitung 25 in eine angepaßte Vorrichtung 27 der in Figur 1 dargestellten Art eingeleitet wird. Aus dieser wird der exakt dosierte Stoff in eine Kammer 30 eingeleitet, in der beispielsweise ein nicht näher dargestellter CVD-Prozeß abläuft.

An einem Ausgang 29 der Vorrichtung 27 steht ein Ist-Signal zur Verfügung, das beispielsweise auf eine nicht dargestellte Anzeige gegeben werden kann. Dieses IstSignal wird über einen Regler 31, der an einem Eingang 33 ein Soll-Signal aufnimmt, zur Regelung des Regelventils 24 und über dieses damit zur Regelung der Dosierung des Stoffes aus dem Behälter 20 verwendet werden. Der Regler 31 gibt dabei ein Regelsignal über eine Leitung 32 auf das Regelventil 24.

Um eine Stoffentmischung zwischen Trägergas und dem zu dosierenden Stoff zu verhindern, ist am Einlaß der Vorrichtung 27 entsprechend dem Einlaß 1 nach Figur 1 zweckmäßigerweise eine entsprechende schematisch dargestellte Einrichtung 28 vorgesehen, die beispielsweise als Verwirbelungsblech verwendet werden kann. Dies ist insbesondere bei Unterdruckanwendungen zweckmäßig, da bei geringen Drücken leicht laminare Strömungsverhältnisse entstehen können und somit keine homogene Vermischung von Trägergas und zu dosierendem Stoff in der Absorptionsküvette vorliegen kann, woraus Meßfehler resultieren können.

Soll ein Verfahren der vorstehend beschriebenen Art bei höheren Temperaturen von beispielsweise bis zu 120°C betrieben werden, so ist es zweckmäßig, zwischen der Quelle für den zu dosierenden Stoff in Form des Behälters 20 und der Vorrichtung 27 eine thermische Isolationseinrichtung und/ oder eine Heizeinrichtung zur Konstanthaltung der Temperatur des zu untersuchenden Stoffes vorzusehen. In Figur 2 sind eine derartige thermische Isolationseinrichtung in Form einer schematisch gestrichelt dargestellten Isolation 23 der Leitung 22 sowie einer schematisch strichpunktiert dargestellten Heizwendel 26 an der Leitung 25 dargestellt.

Das erfindungsgemäße Verfahren besitzt folgende Vorteile:

Es ist eine "in situ" -regelung des Massenflusses im Laufe eines Prozesses möglich.

Die Ansprechzeit beträgt in der Praxis 1 bis 20 Sekunden, wobei beim erfindungsgemäßen Verfahren die Information in Echtzeit und zeitaufgelöst gewonnen werden kann.
Die Messung ist unabhängig von der Art und der Menge des Trägergases, da inerte Gase, wie beispielsweise H₂, N₂, Ar... insbesondere im Infrarotbereich optisch inaktiv sind.
Das Meßprinzip ist in einem weiten und variablen Bereich der Betriebstemperatur ohne neue Kalibrierung einsetzbar.

Es ist ein Einsatz im Druckbereich von Vakuum über Normaldruck bis zu Überdruck möglich. Für das Meßsystem wird nur ein sehr geringer Eingangsdruck von nur einigen Pascal benötigt, und innerhalb des gesamten Meßsystems erfolgt nur ein sehr geringer Druckabfall, so daß ein Einsatz auch für Stoffe mit sehr niedrigem Dampfdruck möglich ist.
Im Prinzip ist die Regelung für unterschiedliche Stoffe ohne neue Kalibrierung im Konzentrationsbereich von einigen ppm bis zu hochprozentigen Gemischen möglich.

Als Beispiel können für einen CVD-Prozeß von TiN aus der metallorganischen Verbindung Tetrakis-(dimethylamino)-titan - Ti(N(CH₃)₂)₄, die bei Raumtemperatur flüssig ist und einen Dampfdruck von etwa 5 Pa bei 50°C besitzt, folgende Parameter angegeben werden:
Absorptionsbanden der CHₓ Gruppen: ca. 3,6 µm
Leitungs- und Küvettentemperatur: 5 bis 10°C über Verdampfertemperatur
Breitbandige Absorption: 3,3 bis 3,9 µm.

Generell können als Bereiche sämtlicher Parameter die folgenden angegeben werden:
Druck: Vakuum über Normaldruck bis Überdruck
Temperatur: Raumtemperatur bis 200°C
Trägergas-Fluß: 0 bis 10000 sccm
Wellenlängenbereich: 100 bis 10000 nM (UV, sichtbar, IR)
Großer Konzentrationsmeßbereich: einige ppm mit Trägergas bis zu hochprozentigen Gemischen.

Das Verfahren ist so gestaltet, daß es ein Ist-Wertaufnehmer eingesetzt wird, dessen Signal eine Regelstrecke ansteuert und somit aktiv den Massenfluß einstellt, wie dies in Figur 2 dargestellt ist.

Insbesondere vorteilhaft ist der Einsatz des auf der Basis der Lichtabsorption arbeitenden Verfahrens im Unterdruckbereich, was bisher noch nicht in Betracht gezogen worden ist.

Das Verfahren ist so umfassend, daß es bei praktisch allen Dosierungs- und Detektionsproblemen von Stoffen in der Gasphase einsetzbar ist und daher der Einsatz nicht nur auf die Mikroelektronik oder die Beschichtungstechnik beschränkt ist.

Das Verfahren kann ohne Probleme sowohl in eine Gesamtanlagensteuerung integriert werden als auch völlig eigenständig Meßaufgaben übernehmen.

## Patentansprüche

1. Verfahren zur Einstellung des Massenflusses einer zu dosierenden Gaskomponente in einem Gasgemisch mittels optischer Absorption, bei dem
a) die Gesamtheit des die zu dosierende Gaskomponente enthaltenden Gasgemischs von einem Behälter (20) durch ein Regelventil (24) und eine Absorptionsküvette (3) in eine Prozeßkammer (30) geleitet wird,
b) eine Referenzküvette (4) ein Referenzgas enthält,
c) die Küvetten (3,4) optisch durchstrahlt werden und bei dem
d) in einem Detektor (8,9), der die aus den Küvetten (3,4) austretende optische Strahlung aufnimmt, ein Signal erzeugt wird,
das als Ist-Wert einem Regler (31) zugeführt wird, der das Regelventil (24) so austeuert, daß der Massenfluß der zu dosierenden Gaskomponente in gewünschter Weise eingestellt wird.

2. Verfahren nach Anspruch 1,
**dadurch gekennzeichnet**,
daß für die Gase, deren Massenfluß eingestellt wird, ein Eingangsdruck von nur einigen Pa eingestellt wird.

3. Verfahren nach einem der Ansprüche 1 bis 2,
**dadurch gekennzeichnet**,
daß das Verfahren in einem weiten und variablen Bereich der Betriebstemperatur bei gleichbleibender Kalibrierung durchgeführt wird.

4. Verfahren nach einem der Ansprüche 1 bis 3,
**gekennzeichnet**, durch die Verwendung von Gasen im Unterdruckbereich.

5. Verfahren nach einem der Ansprüche 1 bis 4 für Unterdruck,
**gekennzeichnet durch** eine eine Gasentmischung verhindernde Einrichtung (28) im Bereich der Absorptionsküvette (3) derart, daß die Gase im Strahlungsbereich in der Absorptionsküvette (3) durchmischt werden.

6. Verfahren nach Anspruch 5,
**dadurch gekennzeichnet**, daß als die Gasentmischung verhindernde Einrichtung (28) ein Verwirbelungsblech verwendet wird.

7. Verfahren nach einem der Ansprüche 1 bis 6 für Gastemperaturen oberhalb der Raumtemperatur,
**gekennzeichnet durch** eine thermische Isolationseinrichtung (23) und/oder Heizeinrichtung (26) zur Konstanthaltung der Temperatur des zu untersuchenden Gasgemisches von seiner Quelle (20) bis zur Absorptionsküvette (3).

8. Anwendung des Verfahrens nach einem der Ansprüche 1 bis 7, zur Dosierung von dampfförmigen Stoffen, insbesondere während eines Schichtabscheidungsprozesses.

## Claims

1. Method for adjusting the mass flow of a gas component to be metered in a gas mixture, by means of optical absorption, in which
a) all of the gas mixture containing the gas component to be metered is fed from a container (20) via a control valve (24) and an absorption cuvette (3) into a process chamber (30),
b) a reference cuvette (4) contains a reference gas,
c) optical radiation is passed through the cuvettes (3,4), and in which
d) a signal is produced in a detector (8,9) which receives the optical radiation emerging from the cuvettes (3,4), which signal is supplied as measured value to a regulator (31) which controls the control valve (24) such that the mass flow of the gas component to be metered is adjusted in the desired way.

2. Method according to Claim 1, characterized in that an initial pressure of only a few Pa is set for the gases, the mass flow of which is being adjusted.

3. Method according to one of Claims 1 to 2, characterized in that the method is carried out in a wide and variable range of operating temperature at constant calibration.

4. Method according to one of Claims 1 to 3, characterized by the use of gases in the low-pressure range.

5. Method according to one of Claims 1 to 4, characterized by a device (28) preventing gas separation in the region of the absorption cuvette (3) such that the gases are thoroughly mixed in the radiation region in the absorption cuvette (3).

6. Method according to Claim 5, characterized in that a turbulator plate is used as the device (28) preventing gas separation.

7. Method according to one of Claims 1 to 6 for gas temperatures above room temperature, characterized by a thermal isolation device (23) and/or heating device (26) for keeping the temperature of the gas mixture to be examined constant between its source (20) until the absorption cuvette (3).

8. Use of the method according to one of Claims 1 to 7 for metering materials in the vapour phase, in particular during a film deposition process.

## Revendications

1. Procédé pour régler, au moyen d'une absorption optique, le débit massique d'un constituant de gaz à doser dans un mélange gazeux, selon lequel
a) on fait passer la totalité du mélange gazeux, qui contient le constituant gazeux devant être dosé, depuis un réservoir (5), à travers une soupape de régulation (24) et une cuvette d'absorption (3), dans une chambre de processus (30),
b) une cuvette de référence (4) contient un gaz de référence,
c) on projette un rayonnement optique à travers les cuvettes (3,4), et selon lequel
d) dans un détecteur (8,9), qui reçoit le rayonnement optique sortant des cuvettes (3,4), est produit un signal qui est envoyé en tant que valeur réelle à un régulateur (31), qui commande la soupape de régulation (24) de manière que le débit massique du constituant de gaz à doser soit réglé de la manière désirée.

2. Procédé suivant la revendication 1, caractérisé par le fait que pour les gaz, dont on règle le débit massique, on règle une pression d'entrée de seulement quelques Pa.

3. Procédé suivant l'une des revendications 1 et 2, caractérisé par le fait qu'on met en oeuvre le procédé dans une gamme étendue et variable de la température de service, moyennant un étalonnage constant.

4. Procédé suivant l'une des revendications 1 à 3, caractérisé par l'utilisation de gaz dans la gamme de dépression.

5. Procédé suivant l'une des revendications 1 à 4, pour une dépression, caractérisé par un dispositif (28) qui empêche de telle sorte une séparation des gaz, placé dans la zone de la cuvette d'absorption (3), que les gaz sont mélangés de façon intime dans la zone d'irradiation de la cuvette d'absorption (3).

6. Procédé suivant la revendication 5, caractérisé par le fait qu'on utilise une tôle de tourbillonnement en tant que dispositif (28) empêchant une séparation des gaz.

7. Procédé suivant l'une des revendications 1 à 6 pour des températures de gaz supérieures à la température ambiante, caractérisé par un dispositif d'isolation thermique (23) et/ou un dispositif de chauffage (26) pour maintenir constante la température du mélange gazeux à examiner, depuis sa source (60) jusqu'à la cuvette d'absorption (3).

8. Application du procédé suivant l'une des revendications 1 à 7 pour le dosage de substances à l'état de vapeurs, pendant un processus de dépôt de couches.
